# EUROPEAN PATENT APPLICATION

(11) **EP 2 704 226 A2**
(43) Date of publication of application: **05.03.2014**
(21) Application number: 13173163.0
(22) Date of filing: 21.06.2013
(51) Int. Cl.: H01L 51/52

(54) **Substrate for oled and method of manufacturing the same**

(30) Priority: 22.06.2012 KR 20120067315
(71) Applicant: Samsung Corning Precision Materials Co., Ltd., Gyeongsangbuk-do Gumi-si, 730-735 (KR)
(72) Inventor: Yoo, Young Zo, 336-841 Asan-si (KR); Park, June Hyoung, 336-841 Asan-si (KR); Kim, Seo Hyun, 336-841 Asan-si (KR); Park, JeongWoo, 336-841 Asan-si (KR); Lee, Joo Young, 336-841 Asan-si (KR)
(74) Representative: Gulde Hengelhaupt Ziebig & Schneider

(57) **Abstract**

A substrate for an organic light-emitting device (OLED) and a method of manufacturing the same, in which the light extraction efficiency and process efficiency of the OLED can be improved. The substrate (100) for an OLED that includes a base substrate (110), a first metal oxide thin film (120) coating one surface of the base substrate (110), the first metal oxide thin film (120) having a first texture on a surface thereof, a second metal oxide thin film (130) coating the other surface of the base substrate (110), and a third metal oxide thin film (140) coating a surface of the second metal oxide thin film (130).

## Description

### CROSS REFERENCE TO RELATED APPLICATION

The present application claims priority from Korean Patent Application Number 10-2012-0067315 filed on June 22, 2012, the entire contents of which application are incorporated herein for all purposes by this reference.

### BACKGROUND OF THE INVENTION

### Field of the Invention

The present invention relates to a substrate for an organic light-emitting device (OLED) and a method of manufacturing the same, and more particularly, to a substrate for an OLED and a method of manufacturing the same, in which the light extraction efficiency and process efficiency of the OLED can be improved.

### Description of Related Art

In general, an organic light-emitting device (OLED) includes an anode, a light-emitting layer and a cathode. When a voltage is applied between the anode and the cathode, holes are injected from the anode into a hole injection layer and then migrate from the hole injection layer to the organic light-emitting layer, and electrons are injected from the cathode into an electron injection layer and then migrate from the electron injection layer to the light-emitting layer. Holes and electrons that have migrated into the light-emitting layer recombine with each other in the light-emitting layer, thereby generating excitons. When such excitons transit from the excited state to the ground state, light is emitted.

Organic light-emitting displays including an OLED are divided into a passive matrix type and an active matrix type depending on a mechanism that drives an N X M number of pixels which are arranged in the shape of a matrix.

In an active matrix type, a pixel electrode which defines a light-emitting area and a unit pixel driving circuit which applies a current or voltage to the pixel electrode are positioned in a unit pixel area. The unit pixel driving circuit has at least two thin-film transistors (TFTs) and one capacitor. Due to this configuration, the unit pixel driving circuit can supply a constant current irrespective of the number of pixels, thereby realizing uniform luminance. The active matrix type organic light-emitting display consumes little power, and thus can be advantageously applied to high definition displays and large displays.

However, only about 20% of light generated by an OLED is emitted to the outside and about 80% of the light is lost by a wavelength effect originating from the difference in the refractive index between a glass substrate and an organic light-emitting layer which includes an anode, a hole injection layer, a hole carrier layer, a light-emitting layer, an electron carrier layer and an electron injection layer and by a total internal reflection effect originating from the difference in the refractive index between the glass substrate and the air.

In order to overcome this problem, the OLED is provided with optical function layers such as a light extraction layer and a transparent conductive oxide thin film layer. In the related art, such optical function layers were formed via photolithography. However, the costs are increased when using photolithography due to the use of expensive equipment, and, since several optical function layers are manufactured by different processes, the entire processes become complicated, processing time is increased, and the overall manufacturing costs are increased. In addition, the light extraction layer formed via photolithography has problems, such as weak bonding force to a substrate and insufficient endurance. Furthermore, since ITO is used for a transparent conductive oxide thin film layer in the related art, the manufacturing costs are increased.

The information disclosed in the Background of the Invention section is provided only for better understanding of the background of the invention, and should not be taken as an acknowledgment or any form of suggestion that this information forms a prior art that would already be known to a person skilled in the art.

### BRIEF SUMMARY OF THE INVENTION

Various aspects of the present invention provide a substrate for an organic light-emitting device (OLED) and a method of manufacturing the same, in which the light extraction efficiency and process efficiency of the OLED can be improved.

In an aspect of the present invention, provided is a substrate for an OLED that includes: a base substrate; a first metal oxide thin film coating one surface of the base substrate, the first metal oxide thin film having a first texture on a surface thereof; a second metal oxide thin film coating the other surface of the base substrate; and a third metal oxide thin film coating a surface of the second metal oxide thin film.

According to an embodiment of the invention, the first metal oxide thin film may be an outer light extraction layer of the OLED, the second metal oxide thin film may be an inner light extraction layer of the OLED, and the third metal oxide thin film may be a transparent electrode of the OLED.

The second metal oxide thin film may have a second texture on the surface thereof which the third metal oxide thin film coats.

The substrate for an OLED may further include a planarization layer between the second metal oxide thin film and the third metal oxide thin film.

The surface of the second metal oxide thin film which the third metal oxide thin film coats may form a flat surface.

Each of the first to third metal oxide thin films may include a metal oxide, a solid solution of at least two metal oxides, or a multilayer structure of at least two metal oxides selected from the group consisting of ZnO, SnO₂, SiO₂, Al₂O₃ and TiO₂.

The haze value of the outer light extraction layer may be 60% or greater, the haze value of the inner light extraction layer may be 5% or greater, and the haze value of the transparent electrode may be 10% or less. Preferably, a haze value of the outer light extraction layer may be greater than a haze value of the inner light extraction layer. According to the present invention, a haze value represents a percentage of transmitted light that is scattered more than 2.5° from the direction of the incident beam.

In addition, the sheet resistance of the transparent electrode may be 15Ω/□ or less (i.e. 15Ω or less).

In the range of visible light (preferably 380 to 760 nm), the transmittance of the outer light extraction layer may be 40% or greater (preferably for all wavelengths), the transmittance of the inner light extraction layer may be 50% or greater (preferably for all wavelengths), and the transmittance of the transparent electrode may be 70% or greater (preferably for all wavelengths).

Furthermore, the refractive index of the outer light extraction layer may range from 1.4 to 3.0 (for visible light), the refractive index of the inner light extraction layer may range from 1.4 to 3.0 (for visible light), and the refractive index of the transparent electrode may range from 1.7 to 3.0 (for visible light).

Preferably, the second metal oxide film comprises a plurality of particles being embedded within the second metal oxide film, the size of the particles ranging from 50 to 400 nm.

According to an embodiment of the invention, an organic light-emitting device is disclosed, comprising an anode, a light-emitting layer and a cathode, wherein the organic light-emitting device comprises a substrate according to the present invention.

Preferably the organic light-emitting device is a passive matrix type or an active matrix type display driving an N X M number of pixels which are arranged in the shape of a matrix.

Preferably the organic light-emitting device may further include at least one selected from the group of a hole injection layer, a hole carrier layer, an electron carrier layer and an electron injection layer.

Preferably, the first metal oxide thin film covers at least

50% (more preferably 80%) of the base substrate. Preferably, the first metal oxide thin film completely covers light emitting area of the base substrate. Preferably, the light emitting area of the base substrate is such area of the base substrate in which a projection of the light emitting layer of the OLED into the plane of the base substrate overlaps with the base substrate (projection along an axis perpendicular to the light emitting layer). Preferably, the second metal oxide thin film covers at least 50% (more preferably 80%) of the base substrate. Preferably, the second metal oxide thin film completely covers light emitting area of the base substrate. Preferably, the third metal oxide thin film covers at least 50% (more preferably 80%) of the base substrate. Preferably, the third metal oxide thin film completely covers light emitting area of the base substrate.

Preferably, the first texture comprises a plurality of first protrusions which are uniformly distributed over the first metal oxide thin film. Preferably, the second texture comprises a plurality of second protrusions which are uniformly distributed over the second metal oxide thin film.

In another aspect of the present invention, provided is a method of manufacturing a substrate for an OLED. The method includes depositing at least one metal oxide thin film on each of one surface and the other surface of a base substrate via atmospheric pressure chemical vapor deposition (APCVD). Atmospheric pressure in the sense of the present invention preferably ranges between 910 to 1100, more preferably between 960 to 1160, more preferably between 980 to 1140 and still more preferably between 990 to 1130 hPa.

According to an embodiment of the invention, the step of depositing the at least one metal oxide thin film may include depositing a first metal oxide thin film on the one surface of the base substrate as an outer light extraction layer of the OLED; depositing a second metal oxide thin film on the other surface of the base substrate as an inner light extraction layer of the OLED; and depositing a third metal oxide thin film on a surface of the second metal oxide thin film as a transparent electrode of the OLED.

The step of depositing the second metal oxide thin film and the step of depositing the third metal oxide thin film may be carried out after the step of depositing the first metal oxide thin film. Alternatively, the step of depositing the first metal oxide thin film may be carried out after the step of depositing the second metal oxide thin film and the step of depositing the third metal oxide thin film.

The method may further include the step of forming a planarization layer on the second metal oxide thin film between the step of depositing the second metal oxide thin film and the step of depositing the third metal oxide thin film.

The step of depositing the third metal oxide thin film may include doping the third metal oxide thin film with at least one of an n-dopant that includes Ga, Al, F, Si and B or a p-dopant that includes N.

The step of depositing the first metal oxide thin film, the step of depositing the second metal oxide thin film and the step of depositing the third metal oxide thin film may be carried out via in-line processing.

Furthermore, each of the first to third metal oxide thin films may be formed using a metal oxide, or a solid solution of at least two metal oxides selected from the group consisting of ZnO, SnO₂, SiO₂, Al₂O₃ and TiO₂.

According to embodiments of the present invention, since the outer and light extraction layers having a texture are formed on the front and rear surfaces of the substrate, it is possible to increase the light extraction efficiency of the OLED.

In addition, since the inner and outer light extraction layers and the transparent conductive oxide thin film of the OLED are manufactured in line via APCVD, it is possible to decrease processing time and improve functional matchability.

Furthermore, since a metal oxide that is cheaper than ITO which was used in the related art is used for the formation of the light extraction layers and the transparent conductive oxide thin film, it is possible to decrease the manufacturing cost.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

### BRIEF DESCRIPTION OF THE DRAWINGS

FIG. 1 is a cross-sectional view showing a substrate for an organic light-emitting device (OLED) according to an embodiment of the present invention;

FIG. 2 and FIG. 3 are process views sequentially showing a method of manufacturing a substrate for an OLED according to an embodiment of the present invention; and

FIG. 4 to FIG. 7 are scanning electron microscopy (SEM) pictures of the cross-section of a substrate for an OLED, in which the substrate is manufactured by the method of manufacturing a substrate for an OLED according to an embodiment of the present invention.

### DETAILED DESCRIPTION OF THE INVENTION

Reference will now be made in detail to a substrate for an organic light-emitting device (OLED) and a method of manufacturing the same, embodiments of which are illustrated in the accompanying drawings and described below, so that a person having ordinary skill in the art to which the present invention relates can easily put the present invention into practice.

Throughout this document, reference should be made to the drawings, in which the same reference numerals and signs are used throughout the different drawings to designate the same or similar components. In the following description of the present invention, detailed descriptions of known functions and components incorporated herein will be omitted when they may make the subject matter of the present invention unclear.

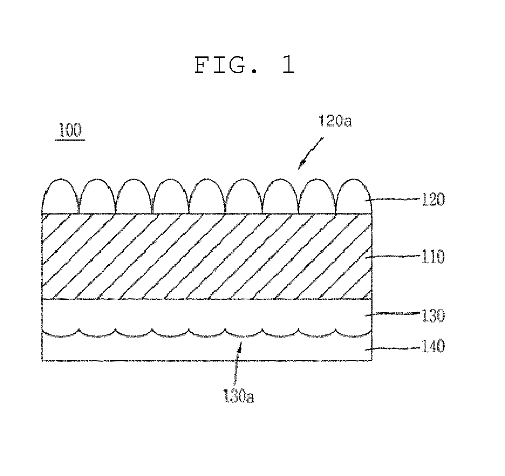

As shown in FIG. 1, a substrate 100 for an OLED according to an embodiment of the present invention is a substrate that is intended to improve the light extraction efficiency of the OLED. The substrate 100 is bonded to one surface of the OLED as one of a pair of substrates of the OLED which face each other. The substrate 100 serves as a passage through which light generated by the OLED is emitted to the outside while protecting the OLED from an external environment.

Although not shown, the OLED has a multilayer structure that includes an anode, an organic light-emitting layer and a cathode which are disposed between the substrate 100 according to this embodiment of the present invention and an encapsulation substrate which opposes the substrate 100. The anode is formed as a part of the substrate 100 according to this embodiment of the present invention. This will be described in more detail later. The cathode is preferably implemented as a metal thin film of Al, Al:Li or Mg:Ag that has a low work function in order to facilitate injection of electrons, but not limited thereto. In the case of a top emission structure, the cathode can have a multilayer structure that includes a semitransparent electrode of a metal thin film of Al, Al:Li or Mg:Ag and a transparent electrode of an oxide thin film of tin oxide (ITO) in order to facilitate transmission of light that is generated by the organic light-emitting layer. In addition, the organic light-emitting layer may include a hole injection layer, a hole carrier layer, a light-emitting layer, an electro carrier layer and an electron injection layer which are sequentially stacked on the anode. In this structure, when a forward voltage is applied between the anode and the cathode, electrons from the cathode migrate to the light-emitting layer through the electron injection layer and the electron carrier layer, and holes from the anode migrate to the light-emitting layer through the hole injection layer and the hole carrier layer. The electrons and holes that have migrated into the light-emitting layer recombine with each other, thereby generating excitons. When such excitons transit from the excited state to the ground state, light is emitted.

The substrate 100 for an OLED according to this embodiment of the present invention that is to be bonded to the OLED as described above includes a base substrate 110, a first metal oxide thin film 120, a second metal oxide thin film 130 and a third metal oxide thin film 140. Here, the base substrate 110, the first metal oxide thin film 120, the second metal oxide thin film 130 and the third metal oxide thin film 140 are manufactured via in-line processing based on atmospheric pressure chemical vapor deposition (APCVD), thereby forming one package.

The base substrate 110 is a transparent substrate which can be made of any material without restrictions as long as it has superior light transmittance and excellent mechanical properties. For example, the base substrate 110 can be made of a polymeric material such as a thermosetting or ultraviolet (UV)-curable organic film or a chemically tempered glass such as a soda-lime glass (SiO₂-CaO-Na₂O) or an aluminosilicate glass (SiO₂-Al₂O₃-Na₂O) The amount of Na can be adjusted depending on the use. Here, the soda-lime glass can be used when the OLED is used for illumination, and the aluminosilicate glass can be used when the OLED is used for a display.

According to an embodiment of the present invention, the base substrate 110 can be implemented as a thin glass having a thickness of 1.5 mm or less. The thin glass is made by a fusion process or a floating process.

The first metal oxide thin film 120 is formed such that it coats one surface of the base substrate 110. For instance, the first metal oxide thin film 120 can coat the upper surface (with respect to the paper surface) of the base substrate 110. Here, it is preferred that the (maximum) thickness of the (textured) first metal oxide thin film 120 that coats the upper surface of the base substrate 110 range from 0.2 to 5 µm. The first metal oxide thin film 120 can include a metal oxide, a solid solution of at least two metal oxides, or a multilayer structure of at least two metal oxides selected from the group consisting of ZnO, SnO₂, SiO₂, Al₂O₃ and TiO₂.

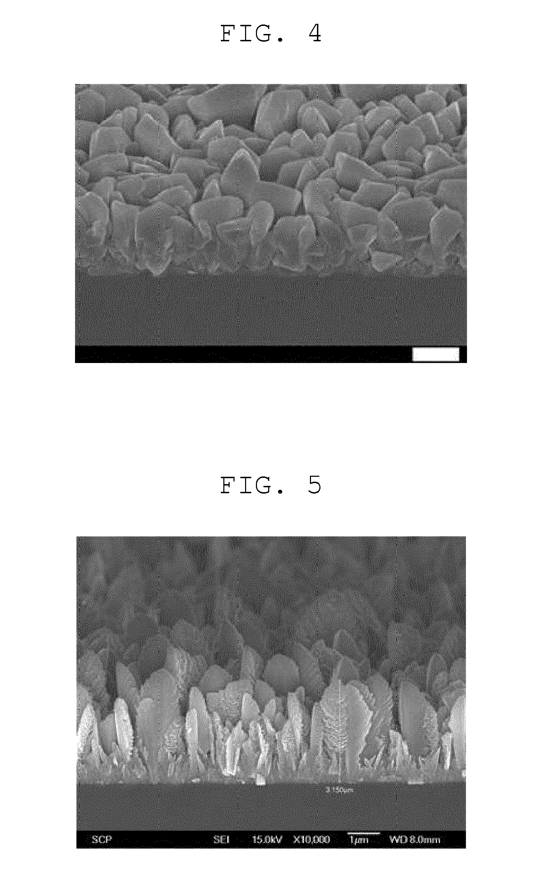

In addition, as shown in FIG. 1, FIG. 4 and FIG. 5, a first texture 120a is formed on the surface of the first metal oxide thin film 120. The first texture 120a serves to scatter light in the visible light range, and can be patterned such that it has the shape of rods, half hexagons or hexagonal prisms or randomly-shaped features. The first texture 120a can be naturally formed when the first metal oxide thin film 120 is being deposited via APCVD. This will be described in more detail later in relation to a method of manufacturing a substrate for an OLED.

As shown in the figures, the first metal oxide thin film 120 formed on the upper surface of the base substrate 110 is the outermost layer of the substrate 100 for an OLED, and serves as an outer light extraction layer of the OLED. The first metal oxide thin film 120 formed as the outer light extraction layer in this fashion has a haze value of 60% or more, a transmittance of 40% or more in the visible light range, and a refractive index ranging from 1.4 to 3.0.

The second metal oxide thin film 130 is formed such that it coats the other surface of the base substrate 110, i.e. the undersurface (with respect to the paper surface) of the base substrate 110 that opposes the oxide thin film 120. It is preferred that the (maximum) thickness of the (textured) second metal oxide thin film 130 on the undersurface of the base substrate 110 range from 0.2 to 5 µm. The second metal oxide thin film 130 can be made of the same material as the first metal oxide thin film 120. Specifically, the second metal oxide thin film 130 can include a metal oxide, a solid solution of at least two metal oxides, or a multilayer structure of at least two metal oxides selected from the group consisting of ZnO, SnO₂, SiO₂, Al₂O₃ and TiO₂.

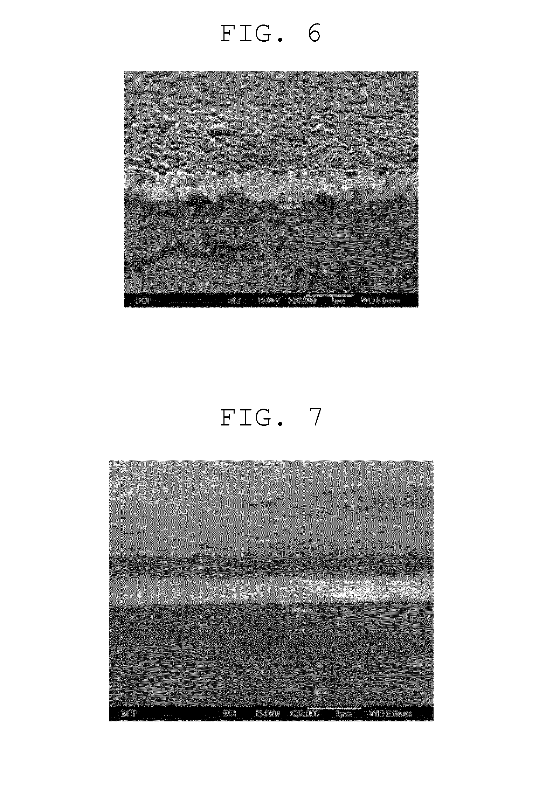

As shown in FIG. 1 and FIG. 6, the second metal oxide thin film 130 has a second texture 130a on one surface thereof. The second texture 130a serves to scatter light, and can be patterned such that it has the shape of rods, rods having a half-hexagon at one side thereof or hexagonal prisms or randomly-shaped features. The surface of the second metal oxide thin film 130 on which the second texture 130a is formed adjoins the third metal oxide thin film 140. Like the first texture 120a, the second texture 130a can be naturally formed when the second metal oxide thin film 130 is being deposited via APCVD. However, one surface of the second metal oxide thin film 130 can form a flat surface.

A planarization layer (not shown) can be formed on the surface of the second texture 130a, i.e. at the interface between the second metal oxide thin film 130 and the third metal oxide thin film 140. The planarization layer (not shown) is formed in the subsequent process, and is intended to guarantee the flatness of the third metal oxide thin film 140 which serves as the transparent electrode, or the anode, of the OLED.

The second metal oxide thin film 130 can include a metal oxide, a solid solution of at least two metal oxides, or a multilayer structure of at least two metal oxides selected from the group consisting of ZnO, SnO₂, SiO₂, Al₂O₃ and TiO₂. The second metal oxide thin film 130 can include at least two metal oxides selected from the same group in which one metal oxide functions as a matrix and the other metal oxide is oversaturated, thereby precipitating as particles. In this case, the size of the particles range from 50 to 400 nm, and at least a minimum thickness that can contain the particles is required.

As shown in the figures, the second metal oxide thin film 130 formed on the undersurface of the base substrate 110 serves as an inner light extraction layer of the OLED. The second metal oxide thin film 130 formed as the inner light extraction layer in this fashion has a haze value of 5% or more, a transmittance of 50% or more in the visible light range, and a refractive index ranging from 1.4 to 3.0.

The third metal oxide thin film 140 is formed such that it coats the surface of the second metal oxide thin film 130. It is preferred that the thickness of the third metal oxide thin film 140 range from 50 to 2000 nm. The third metal oxide thin film 140 can include a metal oxide, a solid solution of at least two metal oxides, or a multilayer structure of at least two metal oxides selected from the group consisting of ZnO, SnO₂, SiO₂, Al₂O₃ and TiO₂. Here, the third metal oxide thin film 140 must have electrical properties since it serves as a transparent electrode of the OLED. For this, the metal oxides can include at least one of n-dopants including Ga, Al, F, Si and B and p-dopants including N. Accordingly, the third metal oxide thin film 140 has a sheet resistance of 15 Ω/□ (15 Q).

As shown in FIG. 1 and FIG. 7, the third metal oxide thin film 140 forms a flat surface. Accordingly, the third metal oxide thin film 140, or the transparent electrode, has a haze value of 10% or less. The transparent electrode has a transmittance of 70% or more in the (preferably whole) visible light range and a refractive index ranging from 1.7 to 3.0 (for visible light).

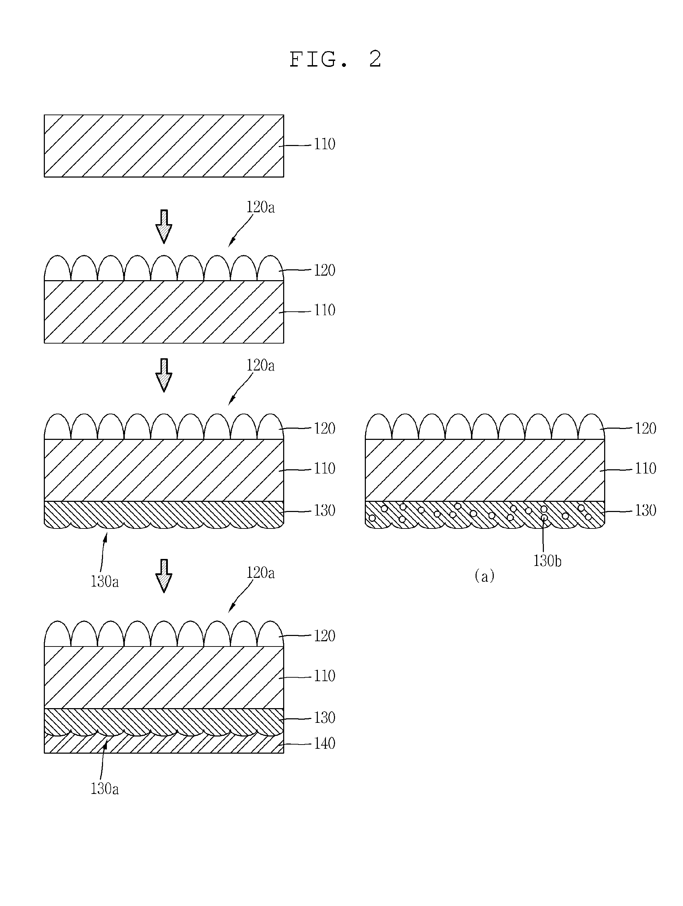

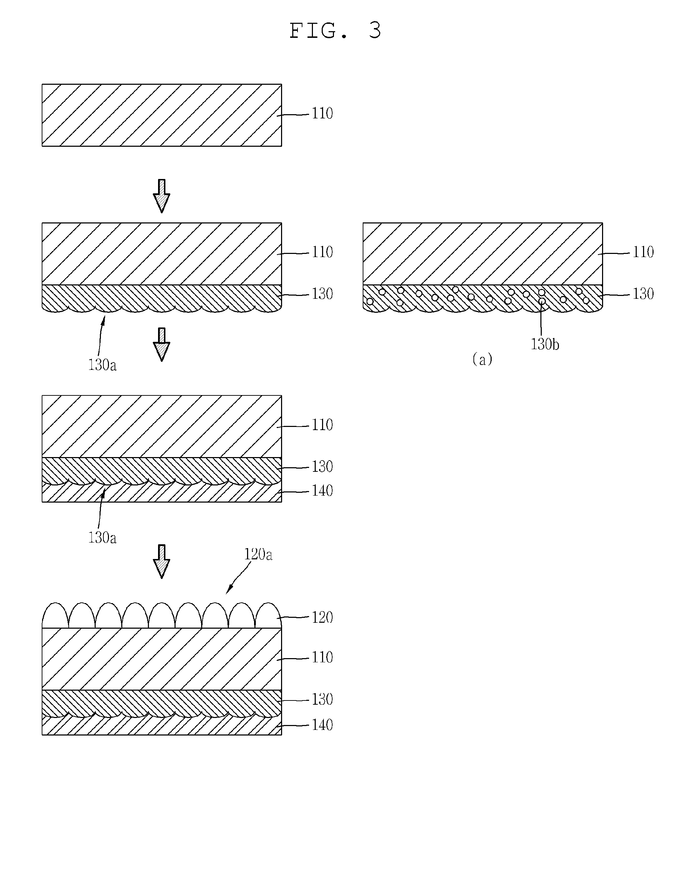

Reference will now be made to a method of manufacturing a substrate for an OLED according to an embodiment of the invention with reference to FIG. 2 and FIG. 3.

The method of manufacturing a substrate for an OLED according to this embodiment of the invention deposits at least one metal oxide thin film on each of one and the other surfaces of a base substrate via APCVD. When the metal oxide thin film is formed via APCVD, a texture is naturally formed on the surface of the metal oxide thin film in the process in which the thin film is being deposited. That is, when the metal oxide thin film is formed via APCVD, it is possible to omit a process of forming the texture. This can consequently simplify the manufacturing process and improve productivity, thereby enabling mass production. Preferably, the APCVD process is carried out under atmospheric pressure.

This APCVD process includes loading the base substrate into a process chamber and then heating the base substrate to a predetermined temperature. Afterwards, a precursor gas and an oxidizer gas are blown into the process chamber in order to form the metal oxide thin film via APCVD. It is preferable to control the precursor gas and the oxidizer gas to be fed along different paths in order to prevent the gases from mixing before entering the process chamber. The precursor gas and the oxidizer gas can be preheated before being fed in order to promote a chemical reaction. The precursor gas can be fed on a carrier gas into the process chamber, the carrier gas being implemented as an inert gas such as nitrogen, helium or argon.

In the case of depositing the metal oxide thin film via APCVD, the surface of the base substrate can be reformed via plasma treatment or chemical treatment before APCVD is started in order to control the shape of the texture that is formed on the surface of the metal oxide thin film. In addition, it is possible to reform the surface of the metal oxide thin film via plasma or chemical treatment after APCVD in order to control the shape of the texture that is formed on the surface of the metal oxide thin film which is formed via APCVD.

As shown in FIG. 2, the method of manufacturing a substrate for an OLED using APCVD includes, first, the step of preparing the base substrate 110. Here, the base substrate 110 can be made of a polymeric material such as a thermosetting or ultraviolet (UV)-curable organic film or a chemically tempered glass such as a soda-lime glass (SiO₂-CaO-Na₂O) or an aluminosilicate glass (SiO₂-Al₂O₃-Na₂O).

In sequence, the first metal oxide thin film 120 which is used as the outer light extraction layer of the OLED is formed on the upper surface of the base substrate 110 via deposition. In order to deposit the metal oxide thin film 120, at least one substance selected from the group of metal oxides consisting of ZnO, SnO₂, SiO₂, Al₂O₃ and TiO₂ or a solid solution thereof can be used. As described above, when the first metal oxide thin film 120 is deposited via APCVD, the first texture 120a is naturally formed on the surface of the first metal oxide thin film 120.

Afterwards, the second metal oxide thin film 130 which is used as the outer light extraction layer of the OLED is deposited on the undersurface of the base substrate 110. In order to deposit the second metal oxide thin film 130, at least one substance selected from the group of metal oxides consisting of ZnO, SnO₂, SiO₂, Al₂O₃ and TiO₂ or a solid solution thereof can be used. Likewise, when the second metal oxide thin film 130 is deposited via APCVD, the second texture 130a is naturally formed on the surface of the second metal oxide thin film 130. Here, it is preferred that the planarization layer (not shown) be formed on the surface of the second texture 130a in order to guarantee the flatness of the third metal oxide thin film 140 which is to be formed in the subsequent process.

The second metal oxide thin film 130 can include a metal oxide, a solid solution of at least two metal oxides, or a multilayer structure of at least two metal oxides selected from the group consisting of ZnO, SnO₂, SiO₂, Al₂O₃ and TiO₂. As shown in the part (a) in FIG. 2, the second metal oxide thin film 130 can be formed such that one substance functions as a matrix and the other substance is oversaturated and precipitates as particles 130b. In this case, the size of the particles 130b ranges from 50 to 400 nm, and the matrix must have at least a minimum thickness such that the particles 130b can be formed therein.

Finally, the third metal oxide thin film 140 which is used as the transparent electrode of the OLED is formed on the surface of the second metal oxide thin film 130 via deposition. In order to deposit the third metal oxide thin film 140, at least one substance selected from the group of metal oxides consisting of ZnO, SnO₂, SiO₂, Al₂O₃ and TiO₂ or a solid solution thereof can be used. In addition, the third metal oxide thin film 140 can be treated with at least one of n-dopants including Ga, Al, F, Si and B and p-dopants including N in order to make the third metal oxide thin film 140 be conductive.

When the third metal oxide thin film 140 is deposited in this fashion, the manufacture of a substrate for an OLED according to this embodiment of the invention is completed. In the method of manufacturing a substrate for an OLED according to this embodiment of the invention, the above-described steps are carried out via in-line processing based on APCVD. It is therefore possible to simplify the thin film deposition processing which has been conducted by different processes in the related art, thereby decreasing a manufacturing cost and improving functional matchability.

As an alternative, as shown in FIG. 3, the first metal thin film 120 can be deposited after the second and third metal oxide thin films 130 and 140 are formed in advance.

The foregoing descriptions of specific exemplary embodiments of the present invention have been presented with respect to the drawings. They are not intended to be exhaustive or to limit the present invention to the precise forms disclosed, and obviously many modifications and variations are possible for a person having ordinary skill in the art in light of the above teachings.

It is intended therefore that the scope of the present invention not be limited to the foregoing embodiments, but be defined by the Claims appended hereto and their equivalents.

## Claims

1. A substrate (100) for an organic light-emitting device comprising:
a base substrate (110) having a first surface arranged on one side of the base substrate (110) and a second surface arranged on an opposite side of the base substrate (110);
a first metal oxide thin (120) film arranged on the first surface of the base substrate (110), the first metal oxide thin film (120) having a first texture (120a);
a second metal oxide thin film (130) arranged on the second surface of the base substrate (110); and
a third metal oxide thin film (140) arranged on the second surface of the base substrate (110).

2. The substrate of claim 1, wherein the second metal oxide thin film (130) has a second texture (130a) arranged on a surface which faces towards the third metal oxide thin film (140).

3. The substrate according to any of the preceding claims, further comprising a planarization layer formed between the second metal oxide thin film (130) and the third metal oxide thin film (140).

4. The substrate according to any of the preceding claims, wherein a surface of the second metal oxide thin film (130) faces towards the third metal oxide thin film (140) comprises a flat surface.

5. The substrate according to any of the preceding claims, wherein each of the first metal oxide thin film (120), the second metal oxide thin film (130) and the third metal oxide thin film (140) comprises a metal oxide, a solid solution of at least two metal oxides, or a multilayer structure of at least two metal oxides selected from a group consisting of ZnO, SnO₂, SiO₂, Al₂O₃ nd TiO₂.

6. The substrate according to any of the preceding claims, wherein a haze value of the first metal oxide thin film (120) is 60% or greater, a haze value of the second metal oxide thin film (130) is 5% or greater, and a haze value of the third metal oxide thin film (140) is 10% or less; and/or wherein a sheet resistance of the third metal oxide thin film (140) is 15Ω/□ or less.

7. The substrate according to any of the preceding claims, wherein, in a range of visible light, an optical transmittance of the first metal oxide thin film (120) is 40% or greater, an optical transmittance of the second metal oxide thin film (130) is 50% or greater, and an optical transmittance of the third metal oxide thin film (140) is 70% or greater.

8. The substrate according to any of the preceding claims, wherein a refractive index of the first metal oxide thin film (120) ranges from 1.4 to 3.0, a refractive index of the second metal oxide thin film (130) ranges from 1.4 to 3.0, and a refractive index of the third metal oxide thin film (140) ranges from 1.7 to 3.0.

9. An organic light-emitting device comprising an anode, a light-emitting layer and a cathode, wherein the organic light-emitting device comprises a substrate according to any of the preceding claims.

10. The organic light-emitting device of claim 9, wherein the first metal oxide thin film (120) is an outer light extraction layer of the organic light-emitting device, the second metal oxide thin film (130) is an inner light extraction layer of the organic light-emitting device, and the third metal oxide thin film (140) is a transparent electrode of the organic light-emitting device.

11. A method of manufacturing a substrate for an organic light-emitting device, comprising depositing at least one metal oxide thin film (120, 130, 140) on each of a first surface and a second surface of a base substrate (110) via atmospheric pressure chemical vapor deposition.

12. The method of claim 11, wherein depositing the at least one metal oxide thin film (120, 130, 140) comprises:
depositing a first metal oxide thin (120) film on the first surface of the base substrate (110);
depositing a second metal oxide thin film (130) on the second surface of the base substrate (110); and
depositing a third metal oxide thin film (140) on a surface of the second metal oxide thin film (130).

13. The method according to any of claims 11 and 12, wherein the method further comprises forming a planarization layer on the second metal oxide thin film (130) between depositing the second metal oxide thin film (130) and depositing the third metal oxide thin film (140); and/or wherein depositing the third metal oxide thin film (140) comprises doping the third metal oxide thin film (140) with at least one of an n-dopant that includes Ga, Al, F, Si and B or a p-dopant that includes N.

14. The method according to any of claims 11 to 13, wherein depositing the first metal oxide thin film (120), depositing the second metal oxide thin film (130) and depositing the third metal oxide thin film (140) are carried out via in-line processing.

15. The method according to any of claims 11 to 14, wherein each of the first metal oxide thin film (120), the second metal oxide thin film (130) and the third metal oxide thin film (140) is deposited using a metal oxide or a solid solution of at least two metal oxides selected from a group consisting of ZnO, SnO₂, SiO₂, Al₂O₃ and TiO₂.
